# EUROPÄISCHE PATENTANMELDUNG

(11) **EP 0 931 621 A2**
(43) Veröffentlichungstag der Anmeldung: **28.07.1999**
(21) Anmeldenummer: 99100949.9
(22) Anmeldetag: 20.01.1999
(51) Int. Cl.: B23K 35/36, B23K 35/14

(54) **Lötverfahren und Lotpaste zur Ausführung dieses Verfahrens**

(30) Priorität: 22.01.1998 DE 19802401
(71) Anmelder: Resma GmbH, 38640 Goslar (DE); FNE Forschungsinstitut für Nichteisen-Metalle Freiberg GmbH, 09599 Freiberg (DE)
(72) Erfinder: Pachschwöll, Heino, 34477 Twistetal (DE)
(74) Vertreter: Manitz, Gerhart, Dr.

(57) **Zusammenfassung**

Die Erfindung betrifft ein Lötverfahren, bei dem einer Lötbehandlung zu unterziehende Werkstücke an den Lötstellen mit einer Lotpulver und die Lotpulverteilchen zusammenhaltendes Bindemittel enthaltenden Lotpaste versehen und dann einer die Lotpulverteilchen zum Schmelzen bringenden Erhitzung unterzogen werden. Erfindungsgemäß ist hierbei vorgesehen, daß ein oxidarmes Lotpulver und ein Bindemittel verwendet wird, das vor und/oder während und/oder nach der Erhitzung vollständig verdampft wird, derart, daß die Werkstücke nach der Lötung zumindest weitgehend frei von Rückständen des Bindemittels sind.

## Beschreibung

Die Erfindung betrifft ein Lötverfahren nach dem Oberbegriff des Patentanspruchs 1 und eine Lotpaste nach dem Oberbegriff des Patentanspruchs 10.

Während in der Mikroelektronik innerhalb der aktiven Bausteine, insbesondere Prozessoren, die Leiterabstände bereits in den Nanometer-Bereich gebracht werden können, arbeitet man auf den einer Lötbehandlung zu unterziehenden Bauteilträgern immer noch mit Leiterabständen im Bereich von Bruchteilen von Millimetern. Rastermaße in der Größenordnung von 700 µm sind gängige Praxis, während unterhalb von 500 µm bereits von der Finepitch-Technik gesprochen wird. Rastermaße unterhalb von 300 µm werden derzeit bei einer Lötbehandlung zu unterziehenden Bauteilträgern als nicht praktikabel angesehen. In einigen sehr anspruchsvollen Anwendungsfallen hat man auch schon Rastermaße von 0,15 mm gewählt, wobei allerdings der Aufwand für die Herstellung der Lötungen beträchtlich und in größerem Maßstab nicht vertretbar ist.

Eine wesentliche Ursache für die Begrenzung der Rastermaße nach unten bei einer Lötbehandlung zu unterziehenden Werkstücken liegt darin, daß beim Löten Flußmittel verwendet werden müssen, deren Rückstände den Widerstandswert zwischen den Leiterbahnen drastisch reduzieren. Die erforderlichen Widerstands-Mindestwerte können daher nur über einen ausreichenden und damit rasterbestimmenden Abstand sichergestellt werden. Als besonders nachteilig für die Halbleiter- und Prozessorfertigung unter Verwendung der üblichen Löttechnik erweist sich, daß hier unter Reinraumbedingungen gearbeitet werden muß. Die übliche Löttechnik ist hierfür nicht geeignet.

Aus diesem Grunde muß bei der Fertigung von aktiven Bausteinen der Mikroelektronik auf völlig andere Verfahren als die Löttechnik, z.B. das Bonden zurückgegriffen werden, oder es muß nach dem Löten eine abschließende, sehr aufwendige Reinigung von widerstandsmindernden Rückständen durchgeführt werden. Die hierfür erforderlichen Kosten sind bei normalen Massenanwendungsfällen nicht zu rechtfertigen.

Man hat nun schon versucht, die Flußmittelanteile für den Lötprozeß erheblich zu reduzieren, indem die Lötung in einer Schutzgas-, insbesondere Stickstoffatmosphäre durchgeführt wurde. Dadurch kann eine Oxidbildung während des Lötvorganges weitgehend vermieden werden. Die bereits vorhandenen Oxide müssen aber durch Aktivatoren reduziert oder abgeführt werden. Hierbei handelt es sich normalerweise um organische Säuren, wobei die nach der Lötung verbleibenden Rückstände im wesentlichen durch die im Bindemittel der Lotpasten vorhandenen Harze gebunden und dadurch zunächst reaktionsunfähig gemacht werden. Die Rückstände können jedoch bei erhöhten Temperaturen und/oder bei längerer Feuchteeinwirkung wieder freigesetzt werden, was schließlich auch noch nach sehr langer Zeit zum Ausfall der auf diese Weise verlöteten Baugruppe führen kann. Im erhöhten Temperaturbereich finden unter Langzeitbedingungen Reaktionen selbst mit den sonst als unbedenklich geltenden Harzsäuren statt. Erst recht tritt dieser Effekt mit den Aktivator-Substanzen auf, wobei lang einwirkende Feuchtigkeit zum Eindringen in die Harz- und Aktivatorbestandteile führt. Oxidative und galvanische Reaktionen mit den Metallkomponenten der Baugruppe sind die Folge. Auf die Dauer führt das zu Störungen und schließlich zu Ausfällen der gesamten Baugruppe. So sind aufgrund elektrolytischer Effekte Migrationserscheinungen bekannt, die schließlich zu Kurzschlüssen führen. Ebenso sind chemische Reaktionen unmittelbar an der Lötstelle bekannt, die auf Dauer zur Schädigung und schließlich zur Zerstörung führen können. Die reduzierten Flußmittelanteile verringern die Störanfalligkeit zwar, aber beseitigen sie nicht.

Das Ziel der vorliegenden Erfindung sind ein Lötverfahren und eine Lotpaste der eingangs genannten Gattung, mit denen auch aktive Elektronikbausteine der Mikroelektronik gelötet werden können, bei denen die Rastermaße deutlich unterhalb von 0,5 mm liegen, ohne daß hierfür ein übermäßiger Aufwand erforderlich ist.

Zur Lösung dieser Aufgabe sind die Merkmale der kennzeichnenden Teile der Ansprüche 1 und 10 vorgesehen. Vorteilhafte Weiterbildungen entnimmt man den Ansprüchen 2, 3 bzw. 11, 12.

Der Erfindungsgedanke ist also darin zu sehen, daß in der erfindungsgemäßen Lotpaste nur solche Bindemittel verwendet werden, die ohne einen speziellen Reinigungsvorgang, sondern allein durch Verdampfen von den Werkstücken bzw. den Lötstellen entfernt werden können. Es verbleiben also auf den Werkstücken weitgehend keine Rückstände des Bindemittels, ohne daß es hierzu eines aufwendigen Reinigungsvorganges bedarf.

Das Basismaterial für die erfindungsgemäß verwendete Lotpaste ist ein extrem oxidarmes Lotpulver. Das Pulver wird mit flußmittelfreien Bindemitteln zu einer Lotpaste angemischt. Diese Bindemittel haben zunächst lediglich die Aufgabe, die Verarbeitungseigenschaften der Lotpaste (Tixotropie, Viskosität usw.) sicherzustellen. Außerdem werden die Metallpartikel des Lotpulvers wirksam gegen einen Sauerstoffkontakt abgeschirmt. Das Bindemittel muß demnach so beschaffen sein, daß es selbst nicht oxidiert und auch keinen Sauerstoff aus der umgebenden Atmosphäre aufnehmen kann. Es ist also ein die Lotpulverteilchen gegen den Sauerstoff der umgebenden Atmosphäre wirksam abschirmendes Bindemittel zu verwenden. Auf diese Weise wird eine gleichbleibende Qualität der Lotpaste ohne unerwünschte Nebenreaktionen gewährleistet.

Eine bevorzugte erfindungsgemäße Lösung sieht vor, daß als einbettende Medien für die Lotpulverteilchen Alkohole verschiedener Wertigkeit und/oder Ester verwendet werden. Auch andere Bindemittelbestandteile mit entsprechenden Eigenschaften sind denkbar.

Die Lotpulvermischung wird so gewählt, daß während des gesamten Lötprozesses definierte Mengen zur Verfügung stehen, die zur Aufrechterhaltung der Oberflächenspannung des schmelzenden Lotes und zur Benetzungsfähigkeit mit den Reaktionspartnern erforderlich sind. Durch Vermengung von Substanzen mit unterschiedlichen Siedetemperaturen wird auf diese Art über eine Kaskade ein einstellbarer, breiter Wirkbereich vorgegeben.

Nachdem auf den zu fügenden Metallteilen und den Lotpulverteilchen noch bestimmte Restmengen von oxidischen Bestandteilen vorhanden sein können, sieht die Erfindung die bevorzugten Weiterbildungen des erfindungsgemaßen Verfahrens nach den Ansprüchen 4 bis 9 vor.

Zur Reduzierung der oxidischen Bestandteile auf den zu fügenden Metalloberflächen und auf den Lotpartikeln soll die Lotpaste also unmittelbar vor dem Eintritt in den Lötprozeß oder während des Lötprozesses in eine Wechselbeziehung mit der umgebenden Atmosphäre treten. Um diese Bedingung zu erreichen, wird eine reduzierende Aktivatoren enthaltende Reaktionsgasatmosphäre geschaffen, die bevorzugt ein in der Dampfphase befindliches Azeotrop ist. Eine praktikable Lösung für die Wechselwirkung mit einer Reaktionsgasatmosphäre entnimmt man der DE 38 13 931 C2.

Im folgenden wird die Erfindung anhand von Beispielen beschrieben:

Es wird eine Lotpaste durch Vermischung folgender Bestandteile hergestellt:
87 Masse-Prozent Lotpulver bestehend aus SnPb 63/37 oder SnAg 96,5/3,5
13 Masse-Prozent einer Mischung aus Isopropanol, Ethandiol (Glycol), Essigsäureisobutylester, Diethylenglycol, Pentanol.

Mit dieser Lotpaste werden die Lötstellen des einer Lötbehandlung zu unterziehenden Werkstückes derart beaufschlagt, daß die zur Aufrechterhaltung der Oberflächenspannung des zu schmelzenden Lotes und zur Benetzungsfähigkeit mit den Reaktionspartnern erforderlichen Mengen zur Verfügung stehen.

Das verwendete Bindemittel sorgt für die erforderlichen pastösen Eigenschaften der Lotpaste, um beispielsweise einen Siebdruck, Schablonendruck oder Dispenserauftrag zu ermöglichen.

Die so vorbehandelten Werkstücke treten nun in den Lötprozeß unter der azeotropen Reaktionsgas-Atmosphäre ein. In der ersten Phase erfolgt gemäß der DE 38 13 939 C2 eine Betauung des noch Kühlen Werkstückes. Die in der Lotpaste enthaltenen Bindemittel treten aufgrund ihrer Hygroskopizität in eine Wechselbeziehung zu den in der kondensierten Atmosphäre vorhandenen Bestandteilen. Hierzu gehören die mit dem Dampf niedergeschlagenen, reduzierenden Aktivatoren. Die erforderliche Betauungsintensität kann aufgrund einer geeigneten Temperatursteuerung während des Prozeßablaufs bestimmt werden. Auf diese Weise wird eine genaue Anpassung an die individuellen Verhältnisse möglich. Da die Alkohol- oder Esterkomponenten oder analogen Bestandteile genau mit den Temperaturen des Reaktionsgas-Lötverfahrens abgestimmt sind, findet ein ständiger, definierter Lösungs-, Abdunstungs- und Siedeprozeß statt.

Die in der Reaktionsgas-Atmosphäre verwendeten Aktivatoren sind so bestimmt, daß nach der Kondensation sie selbst oder die Reaktionsrückstände im Azeotrop abgedampft, sublimiert oder thermisch zersetzt werden. Als besonders geeignet für die Reaktionsgas-Atmosphäre und das daraus resultierende Betauungsprodukt hat sich ein Azeotrop aus Ameisensäure und Wasser herausgestellt. Diese Zusammensetzung ist vorzugsweise für Weichlötverfahren in der Elektronik geeignet.

Geeignete Azeotrope sind:
1. Ein binäres System aus Ameisensäure und Wasser in einem Mischungsverhältnis von bevorzugt 76,5 Gew.-Prozent Ameisensäure und 23,5 Gew.-Prozent Wasser.
2. Ein ternäres System mit zweckmäßig 17,4 Gew.-Prozent Propionsäure, 2 Gew.-Prozent Benzoesäure und 80,6 Gew.-Prozent Wasser verwendet werden.
3. Eine Mischung aus 20,24 Gew.-Prozent Salzsäure und 79,76 Gew.-Prozent Wasser.

Für andere Aufgaben können entsprechende Legierungszusammensetzungen eingesetzt werden. Dabei kann es sich beispielsweise um Cu-, Ag- oder Ni-haltige Pastenbestandteile handeln, wie sie in der Kontakttechnik, im Kühlerbau oder der Installationstechnik gängig sind. Eine entsprechende Anpassung der Bindemittel ist ebenso möglich, sofern die Voraussetzung der zumindest weitgehend vollständigen Verdampfung vor oder während des Lötprozesses gegeben ist. Das ist besonders dann wichtig, wenn es sich um Anwendungen handelt, bei denen in höheren Temperaturbereichen als bei der Weichlösung gearbeitet wird.

Eine weitere Ausführungsform der Erfindung sieht vor, daß die Wechselbeziehung der Pastenbestandteile mit einer nicht-azeotropen Atmosphäre stattfindet. Dabei kann es sich um eine Atmosphäre handelt, die sich aus Komponenten mit gleichen oder angenäherten Siedepunkten oder Siedebereichen zusammensetzt. Solche Gemenge sind z.B. aus einer Komposition höherer Alkohole, Glykol und Säuren herstellbar.

Die Erfindung hat also eine rückstandsfreie Lotpaste zum Gegenstand, bei der als Grundsubstanz ein Metallpulver verwendet wird, welches aus legierten oder unlegierten Metallkomponenten bestehen kann. Es können sowohl Pulverzusammensetzungen für Niedrig- als auch für Hochtemperaturlote verwendet werden.

Als Bindemittel werden aktivatorfreie Substanzen verwendet, wobei insbesondere Alkohole und/oder Ester in Frage kommen. Konkrete Beispiele sind: Isopropanol, Ethandiol. Pentanole, Polyethylenglycol, Essigsäureisobutylester, Essigsäureamylester, Diethylenglycol u.a.

Die reduzierenden Aktivatoren können nicht nur durch Kondensation aus einer Reaktionsgas-Atmosphäre, sondern auch durch Sprühen oder Tauchen auf die der Lötbehandlung zu unterziehenden Werkstücke aufgebracht werden, wobei jedoch auf die weitgehend vollständige Entfernbarkeit auch der Aktivatoren durch Verdampfen und/oder Sublimieren und/oder Zersetzung zu achten ist.

Nach dem Kondensieren der Reaktions-Atmosphäre bzw. dem sonstigen Aufbringen der Aktivatoren können vor oder während des Lötprozesses verschiedene Reaktionen stattfinden, um eine zumindest weitgehende Rückstandsfreiheit während des eigentlichen Lötvorganges zu gewährleisten.

Zum einen kann es sich um Spaltungen von Verbindungen unter thermischem Einfluß handeln; es kann aber auch eine chemische Verbindung entstehen, zum Beispiel ein Ester aus den beteiligten Säuren und Alkoholen. Diese Substanzen dampfen in aller Regel mit ab. Die Ameisensäure hingegen wird oberhalb von 150°C in Kohlendioxid und Wasser gespalten. Die Salze der Ameisensäure (Formiate) werden entweder ebenfalls gespalten, zum Beispiel, Kupferformiat oberhalb von 100°C in Kupfer, Kohlendioxid und Wasser. Andere Formiate oder Salze anderer Säuren könnten auch karbonisieren. Dann verblieben eventuell äußerst geringe Rückstände. Aber es wären durch die Umwandlung keine dissoziierenden und damit reaktionsfähige Bestandteile vorhanden, worauf es in erster Linie ankommt.

Weitere Bestandteile des Bindemittels mit ähnlichen Eigenschaften können niedrig schmelzende Wachse allein oder in Verbindung mit Alkoholen sein. Ebenso sind Phenole oder niedrig siedende Öle allein oder in Hinblick auf die Hygroskopizität in der Mischung mit Alkoholen und/oder Estern denkbar.

Wenn Atmosphären und/oder Azeotrope verwendet werden, die keine oder nur geringe Wasseranteile haben, lassen sich auch andere, damit in Reaktion gehende Bindemittel als Pastenbestandteil verwenden.

Bei solchen Substanzen kann es sich um Einstoffsysteme handeln, zum Beispiel Glycole oder Glycerine. Sie können aber ebenso gut als Gemische vorhanden sein, die lediglich im Siedepunkt nebeneinander liegen, aber kein Azeotrop bilden, zuin Beispiel schwerere Alkohole und chlorierte Wasserstoffe oder Öle.

Es können in einem vorangeschalteten Prozeßschritt chemisch oder physikalisch aktive Reagenzien zugeführt werden, die zum Beispiel die ausgehärtete oder angetrocknete Paste anlösen und die Hygroskopizität herbeiführen oder steigern. Ferner können basische oder saure Medien zugeführt werden, die erst unter thermischem Einfluß aktiv werden. Es soll darauf geachtet werden, daß die Azidität einer aufdestillierten Komponente aus der Atmosphäre im Fügeverfahren durch basische Spaltprodukte nach oder während des Fügevorganges insbesondere zeitabhängig neutralisiert wird. Zur Anlösung und zur Einleitung oder Steigerung der Hygroskopizität kann das eine Zuführung von zum Beispiel Alkoholen und/oder Estern beispielsweise in einer vorgeschalteten Sprühstation sein.

Solche Systeme können unter solchen Umständen auch parallel zu einem Azeotrop eingesetzt werden. Die Ausfällung kann zum Beispiel durch fraktionierte Destillation erfolgen. Es ist aber auch ein Gemenge im sogenannten Kochsumpf möglich.

Ein weiterer vorteilhafter Effekt könnte dadurch erzielt werden, daß eine chemische Reaktion von Bindemitteln innerhalb der Paste und den Anteilen der Atmosphäre dahingehend herbeigeführt wird, daß es zu einer Plymerisation oder Polykristallisation kommt. Das macht es dann noch nicht einmal erforderlich, daß die metallischen Anteile der Paste schmelzen. Unter diesen Bedingungen handelt es sich um einen leitfähigen Klebstoff.

Die Vorgänge der Polymerisation oder der Polykristallisation und der des Aufschmelzens können an den so präparierten Fügestellen zeitgleich oder taktabgestimmt nacheinander verlaufen.

Auf diese Art können Acryle unter dem Einfluß von Feuchtigkeit durch die Betauung ausgehärtet werden. Bei der Verwendung von Epoxiden sind auch katalytische Effekte zur Einleitung des Aushärtevorganges denkbar. Die Lötung kann innerhalb desselben Durchlaufes parallel oder nacheinander erfolgen.

## Patentansprüche

1. Lötverfahren, bei dem einer Lötbehandlung zu unterziehende Werkstücke an den Lötstellen mit einer Lotpulver und die Lotpulverteilchen zusammenhaltendes Bindemittel enthaltenden Lotpaste versehen und dann einer die Lotpulverteilchen zum Schmelzen bringenden Erhitzung unterzogen werden,
dadurch gekennzeichnet,
daß ein oxidarmes Lotpulver und ein Bindemittel verwendet wird, das vor und/oder während und/oder nach der Erhitzung in flüchtige, insbesondere vollständig verdampfbare und/oder lötunschädliche Bestandteile zersetzt und/oder vollständig verdampft wird, derart, daß die Werkstücke nach der Lötung zumindest weitgehend frei von Rückständen, insbesondere lötschädlichen Rückständen des Bindemittels sind.

2. Verfahren nach Anspruch 1,
dadurch gekennzeichnet,
daß ein flußmittelfreies Bindemittel verwendet wird.

3. Verfahren nach Anspruch 1 oder 2,
dadurch gekennzeichnet,
daß das Bindemittel niedrig- bis hochschmelzende Kohlenwasserstoffe, insbesondere Alkohole und/oder Alkene und/oder Ester verwendet werden.

4. Verfahren nach einem der vorhergehenden Ansprüche,
dadurch gekennzeichnet,
daß die Werkstücke mit der auf ihnen vorhandenen Lotpaste vor dem Eintritt in den Lötprozeß oder während des Lötprozesses in eine derartige Wechselwirkung mit einer reduzierende Aktivatoren enthaltenden Umgebung, insbesondere Atmosphäre gebracht werden, daß oxidische Bestandteile auf den zu fügenden Metalloberflächen und/oder den Lotpulverteilchen zumindest weitgehend reduziert werden.

5. Verfahren nach Anspruch 4,
dadurch gekennzeichnet,
daß die Atmosphäre einen die Aktivatoren enthaltenden kondensierbaren Dampf aufweist, der auf den mit entsprechend niedriger Temperatur in die Atmosphäre eingebrachten Werkstücken zur Kondensation gebracht wird.

6. Verfahren nach Anspruch 4 oder 5,
dadurch gekennzeichnet,
daß die in der kondensierbaren Atmosphäre enthaltenen Aktivatoren so bestimmt sind, daß vor dem Lötprozeß oder während des Lötprozesses sie selbst oder die Reaktionsrückstände abgedampft und/oder sublimiert und/oder derart thermisch zersetzt werden,
daß nur gasförmige und/oder verdampfbare und/oder lötunschädliche Komponenten entstehen.

7. Verfahren nach einem der Ansprüche 4 bis 6,
dadurch gekennzeichnet,
daß die Reaktionsgas-Atmosphäre und das daraus resultierende Kondensationsprodukt ein Azeotrop ist.

8. Verfahren nach einem der Ansprüche 4 bis 7,
dadurch gekennzeichnet,
daß die Reaktionsgas-Atmosphäre ein Azeotrop aus Ameisensäure und Wasser aufweist.

9. Verfahren nach einem der Ansprüche 4 bis 8,
dadurch gekennzeichnet,
daß das Bindemittel hygroskopisch und die Reaktionsgas-Atmosphäre wasserdampfhaltig ist.

10. Lotpaste mit Lötpulver und die Lotpulverteilchen zusammenhaltendem Bindemittel, insbesondere zur Ausführung des Lötverfahrens nach einem der vorangehenden Ansprüche,
dadurch gekennzeichnet,
daß es aus einem oxidarmen Lotpulver und einem Bindemittel besteht, das durch Erhitzung zumindest weitgehend verdampfbar ist.

11. Lotpaste nach Anspruch 10,
dadurch gekennzeichnet,
daß das Bindemittel flußmittelfrei ist.

12. Lotpaste nach Anspruch 10 oder 11,
dadurch gekennzeichnet,
daß das Bindemittel ein niedrig- bis hochschmelzender Kohlenwasserstoff, insbesondere Alkohol und/oder Alken (Ester) ist.
